(19) **Europäisches Patentamt / European Patent Office / Office européen des brevets**

(11) **EP 4 699 797 A1**

(12) **EUROPEAN PATENT APPLICATION**
published in accordance with Art. 153(4) EPC

(43) Date of publication:
25.02.2026 Bulletin 2026/09

(21) Application number: 24792421.0

(22) Date of filing: 21.03.2024

(51) International Patent Classification (IPC):
*B32B 7/025* (2019.01)   *B32B 7/023* (2019.01)
*B32B 9/00* (2006.01)   *B32B 27/30* (2006.01)

(52) Cooperative Patent Classification (CPC):
H10N 30/857; B32B 7/023; B32B 7/025;
B32B 9/00; B32B 27/30; H10N 30/01;
H10N 30/098; H10N 30/878; H10N 30/883

(86) International application number:
PCT/JP2024/010933

(87) International publication number:
WO 2024/219145 (24.10.2024 Gazette 2024/43)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 19.04.2023 JP 2023068483

(71) Applicant: Kureha Corporation
Chuo-ku
Tokyo 103-8552 (JP)

(72) Inventor: IMAJI, Makoto
Tokyo 103-8552 (JP)

(74) Representative: Hoefer & Partner Patentanwälte
mbB
Pilgersheimer Straße 20
81543 München (DE)

(54) **MULTILAYER PIEZOELECTRIC BODY AND METHOD FOR MANUFACTURING SAME**

(57)  A laminated piezoelectric body having a total light transmittance of 80% or more includes: a piezoelectric film containing a fluorine-based resin as a main component; a transparent conductive layer having a surface resistivity of $1.0 \times 10^4 \, \Omega/\text{sq}$. or less; and one or more coating layers disposed between the piezoelectric film and the transparent conductive layer, the one or more coating layers each having a thickness of $0.05 \, \mu\text{m}$ or more. Each of the one or more coating layers has a refractive index higher than a refractive index of the piezoelectric film and lower than a refractive index of the transparent conductive layer, and a thickness of at least one of the one or more coating layers has a coefficient of variation of 0.05 or less.

[FIG. 1]

10

EP 4 699 797 A1

**Description**

**TECHNICAL FIELD**

The present invention relates to a laminated piezoelectric body and a method for producing the same.

**BACKGROUND ART**

A touch panel is attached to a display of an electronic device and is used for operating the electronic device. There are various types of touch panels, but a capacitive type is adopted because the structure is simple, the touch panel can be produced at a low cost, and the touch panel is relatively likely to be made large.

A touch panel detects a two-dimensional position on a surface of the touch panel by touching the surface of the touch panel with a finger, a pen, or the like. In touch panel input, it is desirable that selection and execution are separated from each other to prevent input misrecognition. Specifically, selection is desirably performed by selecting a two-dimensional position on the touch surface and applying pressure to the touch surface. Thus, it has been examined to apply a pressure sensor for detecting the pressure on the touch surface to the touch panel.

For example, Patent Document 1 discloses a touch sensor including a capacitance sensor that detects a touch position and a piezoelectric sensor that is disposed on a back surface of the capacitance sensor and detects pressing. As a transparent electrode of the capacitance sensor, a transparent conductive film having high transparency and suppressed color tone is used, which is obtained by forming a conductive film of an indium-tin composite oxide (ITO) on a polymer film and then heating the film at about 150°C to increase crystallinity of ITO. Similarly to this, the piezoelectric sensor is also required to have high transparency and suppressed color tone from the viewpoint of ensuring high visibility of a display image.

As a piezoelectric film to be used for the piezoelectric sensor, there is known a piezoelectric film containing a polymer material such as polylactic acid or a fluorine-based resin, and in particular, it is known that a piezoelectric film containing a fluorine-based resin has a high piezoelectric constant. However, the piezoelectric film containing a fluorine-based resin has low heat resistance, and thus, when a conductive film such as ITO is formed to form a transparent electrode on the piezoelectric film, and then a heat treatment for crystallizing the conductive film is performed, the transparency of the piezoelectric film is likely to be impaired. On the other hand, when the conductive film is merely formed on the piezoelectric film containing a fluorine-based resin and the heat treatment for crystallization is not performed, a yellowish color tone derived from the conductive film is likely to be generated. Accordingly, it has been difficult to use a laminated piezoelectric film having a piezoelectric film in a touch panel.

In contrast, Patent Document 2 discloses a laminated piezoelectric body having a piezoelectric film, a first coating layer, a second coating layer, and a transparent conductive layer in this order. It is disclosed that a laminated piezoelectric body having high transparency and suppressed color tone can be obtained by optimizing a refractive index of each layer.

**CITATION LIST**

**PATENT DOCUMENT**

Patent Document 1: JP 2017-215960 A
Patent Document 2: WO 2022/196198

**SUMMARY OF INVENTION**

**TECHNICAL PROBLEM**

However, according to the studies of the present inventors, it has been found that a laminated piezoelectric body in which a plurality of coating layers having different refractive indices are laminated on a piezoelectric film containing a fluorine-based resin as shown in Patent Document 2 has a problem that interference fringes are generated when viewed under a three-wavelength light source.

The present invention has been made in view of the above circumstances, and an object thereof is to provide a laminated piezoelectric body which has high transparency and can suppress interference fringes when viewed under a three-wavelength light source, and a method for producing the same.

**SOLUTION TO PROBLEM**

[1] A laminated piezoelectric body having a total light transmittance of 80% or more, the laminated piezoelectric body including: a piezoelectric film containing a fluorine-based resin as a main component; a transparent conductive layer having a surface resistivity of $1.0 \times 10^4$ $\Omega$/sq. or less; and one or more coating layers disposed between the piezoelectric film and the transparent conductive layer, the one or more coating layers each having a thickness of 0.05 $\mu$m or more, in which each of the one or more coating layers has a refractive index higher than a refractive index of the piezoelectric film and lower than a refractive index of the transparent conductive layer, and a thickness of at least one of the one or more coating layers has a coefficient of variation of 0.05 or less.

[2] The laminated piezoelectric body according to [1], in which the piezoelectric film has a refractive index of 1.30 or more and 1.50 or less, and the transparent conductive layer has a refractive index of 1.80 or more and 2.20 or less.

[3] The laminated piezoelectric body according to [1] or [2], in which the one or more coating layers include a coating layer A having a refractive index of 1.40 or more and less than 1.60, and a thickness of the coating layer A has a coefficient of variation of 0.05 or less.

[4] The laminated piezoelectric body according to [3], in which the one or more coating layers further include a coating layer B disposed between the coating layer A and the transparent conductive layer, the coating layer B has a refractive index of 1.60 or more and less than 1.80, and a thickness of the coating layer B has a coefficient of variation of 0.05 or less.

[5] The laminated piezoelectric body according to any one of [1] to [4], further including a coating layer D disposed on a surface of the piezoelectric film on a side opposite to a surface on which the one or more coating layers are disposed, in which the coating layer D has a refractive index of 1.40 or more and less than 1.60.

[6] The laminated piezoelectric body according to any one of [1] to [5], further including a carrier film disposed on a surface of the piezoelectric film on a side opposite to a surface on which the one or more coating layers are disposed.

[7] The laminated piezoelectric body according to any one of [1] to [6], in which the fluorine-based resin is a polymer containing a structural unit derived from vinylidene fluoride as a main component.

[8] A method for producing the laminated piezoelectric body described in any one of [1] to [7], the method including: preparing a piezoelectric film containing a fluorine-based resin as a main component; bonding a carrier film to a surface of the piezoelectric film; applying a coating liquid to a surface of the piezoelectric film other than the surface to which the carrier film has been bonded and then drying the coating liquid to form one or more coating layers; and on the one or more coating layers, forming a transparent conductive layer containing a metal oxide.

[9] The method for producing the laminated piezoelectric body according to [8], in which the carrier film has a Young's modulus at 25°C of 1.0 GPa or more.

[10] The method for producing the laminated piezoelectric body according to [8] or [9], in which the preparing of the piezoelectric film includes stretching the film containing a fluorine-based resin as a main component and then subjecting the film to a polarization treatment.

**ADVANTAGEOUS EFFECTS OF INVENTION**

According to the present invention, it is possible to provide a laminated piezoelectric body that has high transparency and can suppress interference fringes when viewed under a three-wavelength light source, and a method for producing the same.

**BRIEF DESCRIPTION OF DRAWINGS**

FIG. 1 is a schematic cross-sectional view illustrating a laminated piezoelectric body according to a present embodiment
FIGS. 2A to 2F are schematic cross-sectional views illustrating a method for producing a laminated piezoelectric body according to a present embodiment.
FIGS. 3A to D are schematic cross-sectional views each illustrating a laminated piezoelectric body according to a modified example.

**DESCRIPTION OF EMBODIMENTS**

As described above, when a laminated piezoelectric body is viewed under a three-wavelength light source, interference fringes may occur. The three-wavelength light source is a light source that emits light in which three wavelength regions of three primary colors (blue, green, and red) of light are emphasized, and for example, a daylight white fluorescent lamp of a three-wavelength region emission type is known. Under such a three-wavelength light source, a color appears brighter and more vivid than under a normal light source. Thus, when there is unevenness in interference of light, the interference unevenness is likely to be emphasized and is likely to be recognized as interference fringes.

According to the studies of the present inventors, it has been found that the interference fringes observed under the three-wavelength light source are likely to occur in a case where there is a difference in refractive index between the piezoelectric film and the coating layer or between the coating layer and the transparent conductive layer, and the thickness of the coating layer greatly varies. In particular, the variation in thickness of the coating layer is likely to occur due to low flatness of the piezoelectric film. It is considered that the low flatness of the piezoelectric film is caused by wrinkles formed in the process of performing a stretching treatment or a polarization treatment of a film containing a fluorine-based resin as a main component to cause the piezoelectric film to exhibit a high piezoelectric effect. That is, among piezoelectric films containing a fluorine-based resin as a main component, a piezoelectric film having a higher piezoelectric effect (piezoelectric constant $d_{33}$) is likely to have lower surface flatness.

In contrast, in an embodiment of the present invention, for example, in a state where the flatness is enhanced by supporting one surface of the piezoelectric film with a carrier film, when the coating layer is formed on the other surface of the piezoelectric film, the variation in thickness of the coating layer can be adjusted to a certain level or less. This can suppress the occurrence of interference fringes when viewed under the three-wavelength light source.

Hereinafter, a laminated piezoelectric body according to an embodiment of the present invention and a method for producing the same will be specifically described.

1. Laminated Piezoelectric Body

A laminated piezoelectric body according to an embodiment of the present invention includes a piezoelectric film, a transparent conductive layer, and one or more coating layers disposed between the piezoelectric film and the transparent conductive layer and having a thickness of 0.05 μm or more.

Each of the one or more coating layers has a refractive index higher than a refractive index of the piezoelectric film and lower than a refractive index of the transparent conductive layer. These coating layers are preferably formed by a wet process. The thickness of at least one, preferably all, of the one or more coating layers has a coefficient of variation adjusted to 0.050 or less.

The coefficient of variation (CV) of the thickness of the coating layer can be determined as a value obtained by dividing a standard deviation (SD) of the thickness by an arithmetic average (AV). Specifically, the thickness of the coating layer is measured using a spectral interference-type thickness meter, and an arithmetic average value Xave of the thickness is calculated from Equation (1) described below, and the standard deviation (SD) of the thickness is calculated from Equation (2) described below. Then, these are substituted in Equation (3) to determine the coefficient of variation (CV) of the thickness. Here, n is the number of measurement points, and xi is the i-th thickness.

[Math. 1]

Equation (1):

$$X_{ave} = \frac{1}{n}\sum_{i=1}^{n} x_i$$

[Math. 2]

Equation (2):

$$SD = \sqrt{\frac{1}{n}\sum_{i=1}^{n}(x_i - x_{ave})^2}$$

[Math. 3]

Equation (3):

$$CV = \frac{SD}{x_{ave}}$$

Note that the transparent conductive layer may be disposed on only one surface of the piezoelectric film, or may be disposed on each of the one surface and the other surface. In addition, in a case where the transparent conductive layer is disposed only on one surface of the piezoelectric film, another coating layer may be further disposed on the other surface of the piezoelectric film.

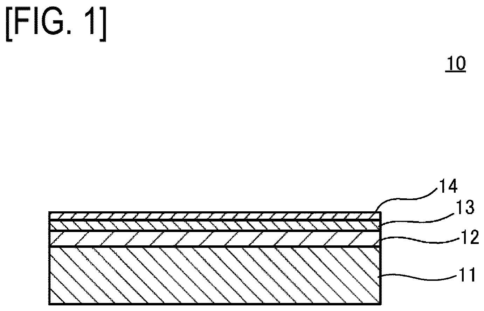

FIG. 1 is a schematic cross-sectional view illustrating a configuration of a laminated piezoelectric body 10 according to an embodiment of the present invention. For example, in FIG. 1, the laminated piezoelectric body 10 includes a piezoelectric film 11, a coating layer A12, a coating layer B13, and a transparent conductive layer 14.

The coating layer A12 is, for example, a hard coat layer, and the coating layer B13 is, for example, an optical adjustment layer, each having a thickness of 0.05 μm or more. The coating layer A12 has a refractive index higher than a refractive index of the piezoelectric film 11 and lower than a refractive index of the transparent conductive layer 14. The coating layer B13 has a refractive index higher than the refractive index of the coating layer A12 and lower than the refractive index of the transparent conductive layer 14. Specifically, the refractive index of the coating layer A12 is preferably 1.40 or more and less than 1.60, and the refractive index of the coating layer B13 is preferably 1.60 or more and less than 1.80.

In the present specification, the refractive index means a refractive index at a wavelength of 589 nm.
The refractive index of the piezoelectric film can be measured in accordance with JIS K 7142:2014 (ISO 489:1999) except that the measuring temperature is changed to 25.0 ± 1.0°C. Specifically, a refractive index is measured three times by using an Abbe refractometer and making a D-line (589 nm) of sodium incident on the piezoelectric film, and the average of the measured values is taken as the refractive index.
The refractive index of each of the layers other than the piezoelectric film can be determined by measuring psi (Ψ) and delta (Δ) with a multi-incident angle high-speed spectroscopic ellipsometer (M-2000, available from J.A. Woollam Company) and calculating a refractive index at a wavelength of 589 nm therefrom.

The thickness of at least one, preferably both, of the coating layer A12 and the coating layer B13 has a coefficient of variation adjusted to 0.05 or less. Hereinafter, the layers will be specifically described.

1-1. Piezoelectric Film

The piezoelectric film contains a fluorine-based resin as a main component. The expression "containing a fluorine-based resin as a main component" means that a content of a fluorine-based resin contained in the piezoelectric film is 50 mass% or more. The content of the fluorine-based resin is preferably 60 mass% or more, and more preferably 80 mass% or more. The upper limit of the content is not particularly limited, and may be 100 mass% or 90 mass% or less.

Among the fluorine-based resins, from the viewpoint of easily obtaining a high piezoelectric effect, the fluorine-based resin is preferably a polymer containing, as a main component, a structural unit derived from vinylidene fluoride.

The expression "containing a structural unit derived from vinylidene fluoride as a main component" means that a content of the structural unit derived from vinylidene fluoride in the polymer is 50 mass% or more with respect to the total amount of the structural units of the polymer. The content of the structural unit derived from vinylidene fluoride in the polymer is more preferably 70 mass% or more, still more preferably 80 % or more, and still even more preferably 90 % or more, with respect to the total amount of structural units of the polymer. As the content of the structural unit derived from vinylidene fluoride is larger, a higher piezoelectric effect is more likely to be achieved. The upper limit value of the content is not particularly limited, and may be 100 mass% or 90 mass% or less.

The polymer may further include a structural unit derived from a monomer copolymerizable with vinylidene fluoride as long as the effects of the present invention are not impaired. Examples of the monomer copolymerizable with vinylidene fluoride include fluorine-containing monomers, such as trifluoroethylene, tetrafluoroethylene, hexafluoropropylene, chlorotrifluoroethylene, and vinyl fluoride. Note that two or more types of these monomers may be contained.

Among them, the fluorine-based resin is preferably a vinylidene fluoride homopolymer from the viewpoint of easily increasing the piezoelectric constant $d_{33}$ of the piezoelectric film and enhancing sensitivity of a pressure sensor to which the piezoelectric film is applied.

The piezoelectric film preferably has a piezoelectric constant $d_{33}$ of 7 pC/N or more and 40 pC/N or less. When the piezoelectric constant $d_{33}$ of the piezoelectric film is 7 pC/N or more, the amount of charge to be generated by the piezoelectric effect is larger, and thus pressure sensitivity can be further enhanced. When the piezoelectric constant $d_{33}$ of the piezoelectric film is 40 pC/N or less, it is possible to further reduce a decrease in flatness of the surfaces of the piezoelectric film caused by, for example, the polarization treatment, and thus to further reduce interference fringes. From the same viewpoint, the piezoelectric constant $d_{33}$ of the piezoelectric film is more preferably 10 pC/N or more and 40 pC/N or less, still more preferably 13 pC/N or more and 35 pC/N or less, and particularly preferably 15 pC/N or more and 30 pC/N or less.

The piezoelectric constant $d_{33}$ of the piezoelectric film can be calculated by measuring an amount of charge to be generated when a stress is applied to the piezoelectric film in the thickness direction thereof at a constant rate, and the piezoelectric constant $d_{33}$ can be measured in accordance with ISO 19622:2018, which is a test method for a piezoelectric

constant $d_{33}$ of piezoelectric ceramics by a direct quasi-static method ($d_{33}$ meter method, Berlincourt method). Specifically, a sample of the piezoelectric film is clipped at 1.0 N, and a generated charge when a force of 0.15 N and 110 Hz is applied is read using a piezoelectric constant measuring device (for example, PiezoMeter System PM300, available from PIEZOTEST Pte Ltd.).

The piezoelectric constant $d_{33}$ of the piezoelectric film can be adjusted mainly by a type of the resin contained in the piezoelectric film and production conditions (conditions for the polarization treatment and the stretching treatment). For example, among fluorine-based resins, the piezoelectric constant $d_{33}$ of the piezoelectric film is likely to be increased as the resin includes more structural units derived from vinylidene fluoride. In addition, the piezoelectric constant $d_{33}$ of the piezoelectric film is likely to be increased by strengthening the polarization treatment or the stretching treatment.

The refractive index of the piezoelectric film is not particularly limited, but is, for example, preferably 1.30 or more and 1.50 or less, more preferably 1.35 or more and 1.47 or less, and still more preferably 1.38 or more and 1.45 or less.

The piezoelectric film preferably has a thickness of, for example, 25 μm or more and 120 μm or less. When the thickness of the piezoelectric film is 25 μm or more, an amount of charge to be generated by a piezoelectric effect is further increased, and higher piezoelectricity is easily obtained. The thickness of the piezoelectric film is more preferably 30 μm or more and still more preferably 35 μm or more. When the thickness of the piezoelectric film is 120 μm or less, transparency of the piezoelectric film is less likely to be impaired. The thickness is more preferably 100 μm or less, and still more preferably 80 μm or less. From the same viewpoint, the thickness of the piezoelectric film is more preferably 35 μm or more and 80 μm or less.

1-2. Coating Layer A

The coating layer A is disposed between the piezoelectric film and the transparent conductive layer. In the present embodiment, the coating layer A is disposed adjacently to the piezoelectric film (see FIG. 1). The coating layer A fills scratches on the surface of the piezoelectric film to smooth the surface, and makes the surface of the piezoelectric film less likely to be scratched during the production of the laminated piezoelectric body. This can further reduce haze of the laminated piezoelectric body.

The thickness of the coating layer A is not particularly limited, but is 0.05 μm or more, preferably 0.3 μm or more and 3.0 μm or less, more preferably 0.5 μm or more and 2.0 μm or less, and still more preferably 0.5 μm or more and 1.5 μm or less.

As described above, the thickness of the coating layer A has a coefficient of variation adjusted to 0.050 or less. When the coefficient of variation of the thickness is 0.050 or less, the thickness unevenness of the coating layer A is reduced, and thus the occurrence of interference fringes in the laminated piezoelectric body can be suppressed. From the same viewpoint, the coefficient of variation of the thickness of the coating layer A is preferably 0.040 or less, and more preferably 0.030 or less. Note that the lower limit value of the coefficient of variation of the thickness of the coating layer A is preferably 0, but may be 0.001 or more.

The coefficient of variation of the thickness of the coating layer A can be adjusted by the flatness of the piezoelectric film. For example, as described below, the coefficient of variation of the thickness of the coating layer A can be reduced by enhancing the flatness of the piezoelectric film when the coating layer A is formed.

As described above, the refractive index of the coating layer A is preferably higher than the refractive index of the piezoelectric film and lower than the refractive index of the transparent conductive layer. Specifically, the refractive index of the coating layer A is preferably 1.40 or more and less than 1.60, more preferably 1.47 or more and 1.57 or less, and still more preferably 1.49 or more and 1.55 or less. When the refractive index of the coating layer A is within the above range, interference fringes can be further suppressed while further enhancing the transmittance.

A difference in refractive index between the coating layer A and the piezoelectric film is preferably 0.01 or more and 0.20 or less. When the difference in refractive index is 0.01 or more, the transmittance can be further enhanced, and when the difference in refractive index is 0.20 or less, interference fringes can be further suppressed.

The coating layer A only needs to be formed of a material satisfying the above refractive index, and is usually a resin layer. The resin layer may be formed by applying an application liquid containing a resin as a coating liquid and then drying the application liquid, or may be formed by applying a curable composition containing a polymerizable compound and then drying and curing the curable composition. In the present embodiment, the coating layer A may be, for example, a hard coat layer. In this case, the coating layer A preferably contains a cured product of a curable composition containing a polymerizable compound.

Polymerizable Compound

The polymerizable compound may be any of a monomer, an oligomer, and a polymer. The polymerizable compound may be a thermosetting compound or an ionizing radiation compound, but is preferably an ionizing radiation compound. The ionizing radiation may typically be ultraviolet rays (UV) or an electron beam (EB).

The ionizing radiation compound is a compound having an ionizing radiation-curable functional group. Examples of the ionizing radiation-curable functional group include ethylenically unsaturated bond groups such as a (meth)acryloyl group, a vinyl group, and an allyl group, and ring-opening polymerizable groups such as an epoxy group and an oxetanyl group. Among them, a compound having an ethylenically unsaturated bond group is preferable, a compound having two or more ethylenically unsaturated bond groups is more preferable, and a polyfunctional (meth)acrylate-based compound is still more preferable. The term "(meth)acrylate" means one or both of acrylate and methacrylate.

Examples of a bifunctional (meth)acrylate-based monomer among the polyfunctional (meth)acrylate-based compounds include ethylene glycol di(meth) acrylate, bisphenol A tetraethoxy diacrylate, bisphenol A tetrapropoxy diacrylate, and 1,6-hexanediol diacrylate. Examples of the (meth)acrylate-based monomer having three or more functional groups include trimethylolpropane tri(meth)acrylate, pentaerythritol tri(meth)acrylate, pentaerythritol tetra(meth)acrylate, dipentaerythritol hexa(meth)acrylate, dipentaerythritol tetra(meth)acrylate, and isocyanuric acid-modified tri(meth)acrylate. The (meth)acrylate-based monomer may be one in which a part of the molecular skeleton is modified, or one modified with ethylene oxide, propylene oxide, caprolactone, isocyanuric acid, alkyl, cyclic alkyl, aromatic, bisphenol, or the like can also be used.

Examples of the polyfunctional (meth)acrylate-based oligomer include acrylate-based polymers such as urethane (meth)acrylate, epoxy (meth)acrylate, polyester (meth)acrylate, and polyether (meth)acrylate. Urethane (meth)acrylate is obtained, for example, by reacting a polyhydric alcohol and an organic diisocyanate with a hydroxy (meth)acrylate.

Polymerization Initiator

In a case where the ionizing radiation-curable compound is an ultraviolet-curable compound, the curable composition preferably contains a photopolymerization initiator. Examples of the photopolymerization initiator include one or more selected from acetophenone, benzophenone, $\alpha$-hydroxyalkylphenone, Michler's ketone, benzoin, benzyl methyl ketal, benzoyl benzoate, $\alpha$-acyloxime ester, and thioxanthones.

Additional Component

The curable composition may further contain an additional component other than the above components as necessary. For example, from the viewpoint of suppressing blocking of the coating layer A during the production or adjusting the refractive index, the curable composition may further contain particles. The particles may be inorganic particles or organic particles.

Examples of the inorganic particles include particles of silica (silicon oxide), titanium oxide, zirconium oxide, aluminum oxide, zinc oxide, tin oxide, and the like, diamond powder, sapphire particles, boron carbide particles, silicon carbide particles, and antimony pentoxide particles. Examples of the organic particles include resin particles of an acrylic resin, an acrylic-styrene copolymer, and a silicone resin. Among them, inorganic particles are preferable, and silica particles are more preferable, from the viewpoint that the transparency of the hard coat layer is hardly impaired. The surface of the inorganic particles may be treated with a surface modifier such as a silane coupling agent.

1-3. Coating Layer B

The coating layer B is disposed between the coating layer A and the transparent conductive layer. The coating layer B can further reduce the color tone of the laminated piezoelectric body by appropriately adjusting the refractive index and the thickness.

Specifically, as described above, the refractive index of the coating layer B is higher than the refractive index of the coating layer A and lower than the refractive index of the transparent conductive layer. The laminated piezoelectric body including such a coating layer B can further reduce the color tone by an interference action between light incident on and reflected by the coating layer A and light reflected by the interface between the coating layer B and the coating layer A.

From the above viewpoint, the refractive index of the coating layer B is preferably 1.60 or more and less than 1.80, more preferably 1.63 or more and less than 1.78, and still more preferably 1.65 or more and 1.75 or less.

A difference in refractive index between the coating layer B and the coating layer A is preferably 0.05 or more. When the difference in refractive index is 0.05 or more, the transmittance can be further enhanced.

The thickness of the coating layer B is not particularly limited, but only needs to be 0.05 μm or more. For example, the thickness of the coating layer B may be 0.05 μm or more and 0.5 μm or less, or may be 0.09 μm or more and 0.18 μm or less. When the thickness of the coating layer B is within the above range, the color tone of the laminated piezoelectric body can be further reduced.

The thickness of the coating layer B has a coefficient of variation adjusted to 0.050 or less. When the coefficient of variation of the thickness is 0.050 or less, the thickness unevenness of the coating layer B is reduced, and thus the occurrence of interference fringes in the laminated piezoelectric body can be further suppressed. The coefficient of variation of the thickness of the coating layer B is more preferably 0.040 or less, and still more preferably 0.030 or less. Note that the lower limit value of the coefficient of variation of the thickness of the coating layer B is preferably 0, but may be 0.001 or more.

The coefficient of variation of the thickness of the coating layer B can also be adjusted in the same manner described above, by the flatness of the piezoelectric film or the coefficient of variation of the thickness of the coating layer A. For example, when the flatness of the piezoelectric film is enhanced or the coefficient of variation of the thickness of the coating layer A is reduced, the coefficient of variation of the thickness of the coating layer B can also be reduced.

The material of the coating layer B may be any material as long as it satisfies such a refractive index. For example, the material may be a material having a refractive index adjusted by adding metal oxide particles to the curable composition exemplified as the material of the coating layer A.

The metal oxide particles are preferably a refractive index material having a refractive index of 1.50 or more. Examples of such metal oxide particles include aluminum oxide, titanium oxide, zirconium oxide, zinc oxide, and tin oxide, and among these, titanium oxide and zirconium oxide are preferable.

1-4. Transparent Conductive Layer

The transparent conductive layer is disposed on the one or more coating layers. In the present embodiment, the transparent conductive layer is disposed on the coating layer B.

A material constituting the transparent conductive layer is not limited, and a metal oxide of at least one metal selected from the group consisting of In, Sn, Zn, Ga, Sb, Ti, Si, Zr, Mg, Al, Au, Ag, Cu, Pd, and W is suitably used. The metal oxide may further contain a metal atom shown in the above group, as necessary. As the metal oxide, ITO, antimony-tin composite oxide (ATO), or the like is preferably used, and ITO is particularly preferably used.

The thickness of the transparent conductive layer is not limited, but is preferably 10 nm or more and less than 55 nm. When the thickness of the transparent conductive layer is 10 nm or more, the surface resistivity can be further reduced, and when the thickness is less than 55 nm, transparency is further less likely to be impaired. From the same viewpoint, the thickness of the transparent conductive layer is more preferably 15 nm or more and less than 45 nm, and still more preferably 20 nm or more and less than 40 nm.

The refractive index of the transparent conductive layer is preferably 1.80 or more and 2.20 or less, more preferably 1.83 or more and 2.00 or less, and still more preferably 1.85 or more and 1.95 or less.

1-5. Other Layers

The laminated piezoelectric body according to the present embodiment may further include another layer other than the above layers. For example, the laminated piezoelectric body may further include a coating layer C having a thickness of less than 0.05 $\mu$m between the coating layer B and the transparent conductive layer. The laminated piezoelectric body may further include a coating layer D disposed on a surface of the piezoelectric film on a side opposite to the surface on which the one or more coating layers are disposed.

1-5-1. Coating Layer C

The coating layer C is a coating layer having a thickness of less than 0.05 $\mu$m. A refractive index of the coating layer C only needs to be higher than the refractive index of the piezoelectric film and lower than the refractive index of the transparent conductive layer, and may be lower than the refractive index of the coating layer A or the coating layer B.

Such a coating layer C may be a thin film of a metal oxide (for example, a silica thin film) formed by, for example, a dry process. The coating layer C can further increase the transmittance of the laminated piezoelectric body, for example. That is, the transmittance of the laminated piezoelectric body can be increased by utilizing an interference phenomenon caused by thin films having different refractive indices.

1-5-2. Coating Layer D

A material and physical properties (thickness, refractive index) of the coating layer D may be the same as the material and physical properties of the coating layer A described above. The coating layer D can further reduce the haze of the laminated piezoelectric body. From the viewpoint of making it more difficult for interference fringes to occur in the laminated piezoelectric body, a difference in refractive index between the coating layer D and the piezoelectric film is preferably small, and is preferably, for example, 0.15 or less. The thickness of the coating layer D may be, for example, 0.3 $\mu$m or more and 2.0 $\mu$m or less. The thickness of the coating layer D also preferably has a coefficient of variation adjusted to 0.050 or less.

1-6. Physical Properties

Total Light Transmittance

The laminated piezoelectric body according to the present embodiment preferably has high transparency from the viewpoint of being applied to a touch panel mounted on an image display device, for example. Specifically, the total light transmittance of the laminated piezoelectric body is preferably 80% or more, and more preferably 85% or more.

The total light transmittance of the laminated piezoelectric body can be measured using a haze meter (for example, "NDH7000SP II", available from Nippon Denshoku Industries Co., Ltd.) based on the method described in JIS K 7361-1.

The total light transmittance of the laminated piezoelectric body can be adjusted by the layer configuration (including the coating layer B and the coating layer C), and the refractive index and thickness of each layer. For example, the total light transmittance can be further increased by providing the coating layer B or the coating layer C.

Piezoelectric Constant

The laminated piezoelectric body preferably has a piezoelectric constant $d_{33}$ of 7 pC/N or more and 40 pC/N or less, for example. When the piezoelectric constant $d_{33}$ of the laminated piezoelectric body is 7 pC/N or more, high pressure sensitivity is likely to be achieved. When the piezoelectric constant $d_{33}$ of the laminated piezoelectric body is 40 pC/N or less, the above-described interference fringes can be further reduced. From the same viewpoint, the piezoelectric constant $d_{33}$ of the laminated piezoelectric body is more preferably 10 pC/N or more and 40 pC/N or less, still more preferably 13 pC/N or more and 35 pC/N or less, and particularly preferably 15 pC/N or more and 30 pC/N or less.

The piezoelectric constant $d_{33}$ of the laminated piezoelectric body can be adjusted mainly by the piezoelectric constant $d_{33}$ of the piezoelectric film. When the piezoelectric constant $d_{33}$ of the piezoelectric film is high, the piezoelectric constant $d_{33}$ of the laminated piezoelectric body is also likely to be high.

Surface Resistivity

The transparent conductive layer of the laminated piezoelectric body preferably has a low surface resistivity from the viewpoint of obtaining more favorable conductivity in the application of a device such as a touch panel. The surface resistivity of the transparent conductive layer is, for example, preferably $1 \times 10^4$ Ω/sq. or less, more preferably $1 \times 10^3$ Ω/sq. or less, and still more preferably 400 Ω/sq. or less. The lower limit value of the surface resistivity of the transparent conductive layer is not particularly limited, but may be, for example, 10 Ω/sq. or more, and preferably 40 Ω/sq. or more. The surface resistivity of the transparent conductive layer can be measured based on a known method described in JIS K 7194 using a resistivity meter, for example.

Thickness of Each Layer

The thickness of each layer constituting the laminated piezoelectric body can be measured using a spectral interference-type thickness meter (for example, "Optical NanoGauge C13027-11" available from Hamamatsu Photonics K.K.). The refractive index of each layer can be measured by the method described in JIS K 7142, and the refractive index of each layer only needs to be set to a value measured by the method described above. A thickness of each layer in a range including the center of the surface of the laminated piezoelectric body is measured at three or more points at 5 mm intervals, and the arithmetic average value thereof can be taken as the thickness of each layer.

Applications

The laminated piezoelectric body according to the present embodiment can be used for various applications. In particular, the laminated piezoelectric body according to the present embodiment exhibits high piezoelectricity while having high transparency and visibility, and thus can be preferably used as a piezoelectric sensor of a touch panel mounted on various electronic devices.

2. Method for Producing Laminated Piezoelectric Body

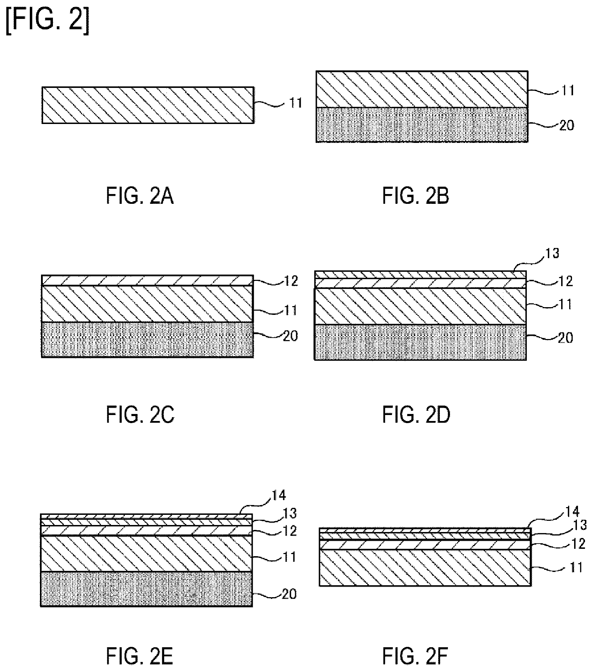

FIGS. 2A to 2F are schematic cross-sectional views illustrating a method for producing a laminated piezoelectric body according to a present embodiment.

The method for producing a laminated piezoelectric body according to the present embodiment includes: 1) a process of preparing a piezoelectric film 11 containing a fluorine-based resin as a main component (see FIG. 2A); 2) a process of bonding a carrier film 20 to one surface of the piezoelectric film 11 (see FIG. 2B); 3) a process of applying a coating liquid to the surface of the piezoelectric film 11 other than the surface to which the carrier film 20 is bonded, and then curing the coating liquid to form a coating layer A12 and a coating layer B13 (see FIGS. 2C and 2D); and 4) a process of forming a transparent conductive layer 14 containing a metal oxide on the coating layer B13 (see FIG. 2E). The method for producing a laminated piezoelectric body may further include a process of peeling off the carrier film 20 (see FIG. 2F).

(1) Preparing Piezoelectric Film

The piezoelectric film containing a fluorine-based resin as a main component may be a commercially available product or may be produced (see FIG. 2A).

In a case where a piezoelectric film containing a fluorine-based resin as a main component is produced, the piezoelectric film can be obtained through a process of subjecting a film containing a fluorine-based resin as a main component to a polarization treatment. The film containing a fluorine-based resin as a main component may be a stretched film or an unstretched film. In the present embodiment, from the viewpoint of exhibiting a high piezoelectric effect, it is preferable to stretch the film containing a fluorine-based resin as a main component and then subject the stretched film to the polarization treatment.

The film containing a fluorine-based resin as a main component can be produced by an arbitrary method such as a melt-extrusion method, a hot press method, or a solution casting method. Among them, from the viewpoint of easily obtaining a piezoelectric film having a predetermined thickness or more, it is preferable that the film containing a fluorine-based resin as a main component is produced by the melt-extrusion method. In the melt-extrusion method, the fluorine-based resin and an additive of any type can be heated and melted in a cylinder of an extruder and then extruded from a die to obtain a film.

The obtained film has a structure in which an $\alpha$-type crystal (the main chain has a helical structure) and a $\beta$-type crystal (the main chain has a planar zigzag structure) are mixed. The $\beta$-type crystal has a large polarization structure. When the film is stretched, the $\alpha$-type crystal can be converted into the $\beta$-type crystal. During stretching, the film is preferably stretched as necessary to convert the fluorine-based resin into the $\beta$-type crystal. The stretching direction may be a TD direction or an MD direction, and is more preferably the MD direction.

The stretching method is not particularly limited, and can be performed by a known stretching method such as a tenter method or a drum method.

A stretching ratio is, for example, 3.0 or more times and 6.0 or less times. When the stretching ratio is 3.0-fold or more, it is easy to adjust the thickness and polarizability of the film to more appropriate ranges. When the stretching ratio is 3.0-fold or more, a dislocation reaction of the $\beta$-type crystals more sufficiently proceeds, and not only higher piezoelectricity is likely to be exhibited but also transparency can be further enhanced. When the stretching ratio is 6.0 or less times, it is possible to further suppress breakage due to stretching.

The obtained stretched film is subjected to a polarization treatment. The polarization treatment can be performed by, for example, applying a DC voltage between a ground electrode and a needle-shaped electrode. The voltage may be adjusted depending on the thickness of the stretched film, and can be, for example, 1 kV or more and 50 kV or less.

As described above, in the present embodiment, the piezoelectric film can be obtained by subjecting the stretched film to the polarization treatment.

(2) Process of Bonding Carrier Film

Subsequently, a carrier film is bonded to one surface of the piezoelectric film (see FIG. 2B).

The bonding of the carrier film can be performed by bonding the carrier film to one surface of the piezoelectric film via an adhesive layer. For example, a release film is peeled off from a laminated film of release film/adhesive layer/carrier film, and the exposed adhesive layer is pressed against one surface of the piezoelectric film, whereby the carrier film can be bonded thereto.

The carrier film is preferably a film having a high Young's modulus from the viewpoint of enhancing the flatness of the surface of the piezoelectric film. Specifically, the Young's modulus of the carrier film at 25°C is preferably 1.0 GPa or more, more preferably 1.5 GPa or more and 6.0 GPa or less, still more preferably 2.0 GPa or more and 5.0 GPa or less, and most preferably 2.5 GPa or more and 4.5 GPa or less. When the carrier film having a Young's modulus satisfying the above range is bonded, the surface of the piezoelectric film can be suitably flattened. Accordingly, when the coating layer A is formed on the other surface of the piezoelectric film by a wet coating method, the coating layer A having small variation in thickness can be formed.

The Young's modulus of the carrier film can be measured by the following procedure.

The carrier film is cut into a rectangular shape having a total length of 100 mm and a width of 10 mm to obtain a test piece. The test piece is set in a tensile tester with a chuck-to-chuck distance of 50 mm to conduct a tensile test at a tensile rate of 50 mm/min in a measuring atmosphere of 25°C. From the obtained stress-strain curve, two points in a minute deformation region (within a strain of 5%) are selected in accordance with JIS K 7161-1, and the Young's modulus is determined from a slope determined from a linear approximation formula.

The type of the carrier film is not particularly limited as long as the Young's modulus satisfies the above range, and is usually a resin film. Examples of the resin constituting the carrier film include polyesters such as polyethylene terephthalate (PET) and polybutylene terephthalate; polyolefins such as polyethylene (PE) and polypropylene (PP); halogen-containing polymers such as polyvinyl chloride (PVC) and polyvinylidene fluoride (PVDF); acrylic polymers such as polymethyl methacrylate; and styrene-based polymers such as polystyrene and styrene-methyl methacrylate copolymers. Among them, PET and PP are preferable, and PET is more preferable from the viewpoint of having a higher Young's modulus. These films each may be an unstretched film or a biaxially stretched film.

The thickness of the carrier film only needs to be such an extent that the surface of the piezoelectric film can be flattened, and is, for example, preferably 35 $\mu$m or more and 200 $\mu$m or less, more preferably 50 $\mu$m or more and 175 $\mu$m or less, and still more preferably 70 $\mu$m or more and 150 $\mu$m or less.

Adhesive Layer

An adhesive layer may be disposed on the carrier film. The adhesive layer is desired to have an adhesive force for attaching the carrier film to the piezoelectric film and to be peelable as necessary. Thus, an adhesive is preferably a material that not only allows a protective film to be attached to the piezoelectric film but also allows the protective film to be peeled off without leaving a paste on the piezoelectric film.

From such a viewpoint, examples of the adhesive include an acrylic adhesive, a rubber-based adhesive, a silicone-based adhesive, a polyester-based adhesive, a polyurethane-based adhesive, a polyamide-based adhesive, an epoxy-based adhesive, a vinyl alkyl ether-based adhesive, and a fluorine-based adhesive. Among them, an acrylic adhesive is preferable from the viewpoint of adhesiveness and peelability.

The adhesive layer preferably has a thickness of, for example, 3 $\mu$m or more and 10 $\mu$m or less.

Release Film

The material of the release film is not particularly limited, and may be, for example, PET.

(3) Process of Forming One or More Coating Layers

A coating liquid is applied to the surface of the piezoelectric film other than the surface to which the carrier film is bonded, to form one or more coating layers (see FIGS. 2C and 2D). In the present embodiment, the coating liquid containing the curable composition is applied onto the other surface of piezoelectric film, and then dried and cured to form the coating layer A.

The coating liquid may further contain a diluting solvent as necessary. As the diluting solvent, a solvent having a polarity close to that of the particles is preferable. Examples of the diluting solvent include organic solvents such as an alcohol-based solvent, a ketone-based solvent, an ester-based solvent, a carbonate-based solvent, and an aromatic solvent.

The coating liquid can be applied by a known wet process method. Typical examples of the wet process method include dip coating, spray coating, spin coating, gravure coating, die coating, roll coating, flow coating, and curtain coating. Among them, a method capable of continuously forming a layer, such as a roll coating method or a gravure coating method, is preferable from the viewpoint of productivity.

The coating liquid can be dried by heating the application liquid. The heating temperature only needs to be a temperature equal to or lower than the thermal deformation temperature of the fluorine-based resin constituting the piezoelectric film within a range in which the solvent can be volatilized and removed, and can be, for example, 40°C or higher and 100°C or lower. The thermal deformation temperature can be measured, for example, in accordance with JIS K 7191-2:2015.

The curing may be performed by heat or by ionizing radiation. The curing by ionizing radiation can be performed by irradiation with ultraviolet rays or an electron beam. Curing by heat and curing by ionizing radiation may be used in combination.

Similarly to this, an application liquid containing the curable composition described above for obtaining the coating layer B is applied onto the obtained coating layer A, and then dried and cured to form the coating layer B.

(4) Process of Forming Transparent Conductive Layer

A transparent conductive layer is formed on the obtained coating layer B (see FIG. 2E). The transparent conductive layer can be formed by a known dry process method such as a sputtering method, a vacuum deposition method, or an ion plating method.

In a case of employing the sputtering method, the above-described inorganic substance contained in the transparent conductive layer, preferably ITO, can be used as a target material.

Examples of the sputtering gas include an inert gas such as Ar. As necessary, a reactive gas such as oxygen gas may be used in combination.

(5) Another Process

The method for producing a laminated piezoelectric body according to the present embodiment may further include another process other than the above processes as necessary. For example, after the process of (4), a process of peeling off the carrier film together with the adhesive layer may be further performed (see FIG. 2F).

3. Modified Examples

Note that although the laminated piezoelectric body having the layer configuration illustrated in FIG. 1 and the method for producing the same have been described in the above embodiments, the present invention is not limited thereto.

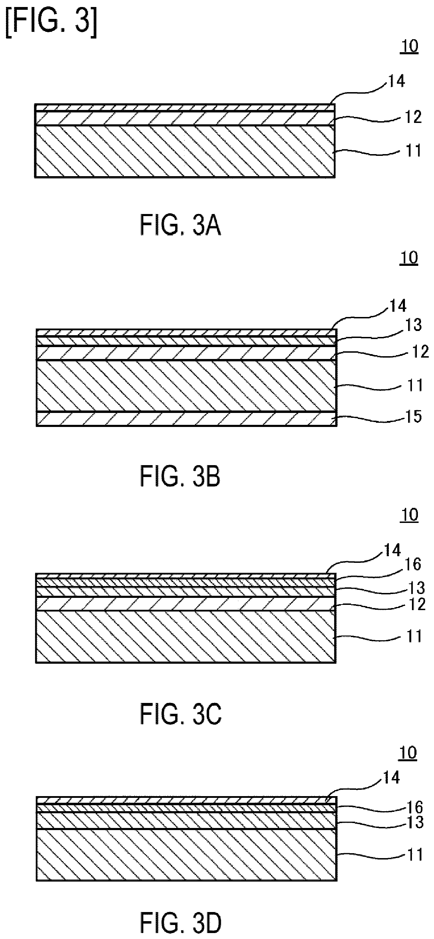

FIGS. 3A to D are schematic cross-sectional views illustrating laminated piezoelectric bodies 10 according to modified examples.

For example, the laminated piezoelectric body 10 does not need to include the coating layer B13 (see FIG. 3A). The laminated piezoelectric body 10 may further include a coating layer D15 on the other surface of the piezoelectric film 11 (see FIG. 3B). The laminated piezoelectric body 10 may further include a coating layer C16 between the coating layer B13 and the transparent conductive layer 14 (see FIG. 3C).

The laminated piezoelectric body 10 does not need to include the coating layer A12 (see FIG. 3D). That is, the coating layer B13 may be adjacent to the piezoelectric film 11. In this case, the thickness of the coating layer B13 is not particularly limited, but may be in the same range as that of the coating layer A12.

**EXAMPLES**

Hereinafter, the present invention will be further described with reference to Examples and Comparative Examples. The technical scope of the present invention is not limited to these.

1. Evaluation of Physical Properties

Refractive Index

The refractive index of the piezoelectric film was measured in accordance with JIS K 7142:2014 (ISO 489:1999) except that the measuring temperature was changed to $25.0 \pm 1.0°C$. Specifically, the refractive index of the piezoelectric film was measured three times by using an Abbe refractometer and making a D-line (589 nm) of sodium incident on the piezoelectric film, and the average of the measured values was taken as the refractive index.

The refractive index of each of the layers other than the piezoelectric film was determined by measuring psi ($\Psi$) and delta ($\Delta$) with a multi-incident angle high-speed spectroscopic ellipsometer (M-2000, available from J. A. Woollam Company) and calculating a refractive index at a wavelength of 589 nm therefrom.

Thickness

The thickness of each layer was measured using a spectral interference-type thickness meter ("Optical NanoGauge C13027-11" available from Hamamatsu Photonics K.K.). Specifically, the thickness of each layer in a range including the center of the surface of the laminated piezoelectric body was measured at 50 points at 5 mm intervals in the TD direction, and the arithmetic average value thereof was taken as the thickness of each layer. Note that the refractive index of each layer was set to the value shown in Table 1.

Coefficient of Variation of Thickness

The coefficient of variation (CV) of the thickness of the coating layer was determined as a value obtained by dividing the standard deviation (SD) of the thickness by the arithmetic average (AV). Specifically, the thickness of the coating layer was measured at 50 points, an arithmetic average value Xave of the thickness was calculated from Equation (1) described below, the standard deviation (SD) of the thickness was calculated from Equation (2) described below, and these were substituted in Equation (3) described below to determine the coefficient of variation (CV) of the thickness. Here, n is the number of measurement points, and xi is the i-th thickness.
[Math. 4]

Equation (1):

$$X_{ave} = \frac{1}{n} \sum_{i=1}^{n} x_i$$

[Math. 5]

Equation (2):

$$SD = \sqrt{\frac{1}{n} \sum_{i=1}^{n} (x_i - x_{ave})^2}$$

[Math. 6]

Equation (3):

$$CV = \frac{SD}{x_{ave}}$$

Young's Modulus

The Young's modulus of the carrier film was measured by the following procedure.

The carrier film was cut into a rectangular shape having a total length of 100 mm and a width of 10 mm to obtain a test piece. The test piece was set in a tensile tester with a chuck-to-chuck distance of 50 mm to conduct a tensile test at a tensile rate of 50 mm/min in a measuring atmosphere of 25°C. From the obtained stress-strain curve, two points in a minute deformation region (within a strain of 5%) were selected in accordance with JIS K 7161-1, and the Young's modulus was determined from a slope determined from a linear approximation formula.

2. Preparation and Evaluation of Laminated Piezoelectric Body

Example 1

(1) Preparation of Piezoelectric Film

A resin film (thickness: 120 $\mu$m) obtained by molding polyvinylidene fluoride (available from KUREHA CORPORATION, vinylidene fluoride homopolymer) was stretched in such a manner that the stretching ratio was 4.2-fold in the MD direction. The film after stretching was subjected to the polarization treatment by applying a DC voltage between a ground electrode and a needle-shaped electrode while the DC voltage was increased from 0 kV to 13.0 kV. The film after the polarization treatment was further heat-treated at 130°C for 1 minute to obtain a piezoelectric film having a refractive index of 1.42 and a thickness of 40 $\mu$m.

(2) Formation of Coating Layer A

Next, a carrier film (polyethylene terephthalate, Young's modulus at 25°C: 4.0 GPa) having a thickness of 125 $\mu$m was bonded to the Y surface of the obtained piezoelectric film at room temperature (25°C) using a laminator, and the resultant was wound into a roll shape. The laminator was set in such a manner that a line speed was 5 m/min and a laminating roll contact pressure was about 0.3 N.

An ultraviolet-curable composition containing an acrylic compound and amorphous silica was applied onto the X surface of the piezoelectric film of the obtained laminate, dried at 80°C, and then irradiated with ultraviolet rays to form a coating layer A (thickness: 728 nm, refractive index: 1.50).

(3) Formation of Transparent Conductive Layer

Next, an indium tin oxide (ITO) film was formed on the obtained coating layer A by a reactive sputtering method, thereby forming a transparent conductive layer having a refractive index of 1.92 and a thickness of 23 nm. As the target, a sintered body material containing 97 mass% of indium oxide and 3 mass% of tin oxide was used. Thus, a laminated piezoelectric body was obtained.

[Example 2]

(1) Preparation of Piezoelectric Film

A piezoelectric film (thickness: 40 $\mu$m, refractive index: 1.42) was prepared in the same manner as in Example 1.

(2) Formation of Coating Layer D

Next, a carrier film (polyethylene terephthalate) having a thickness of 125 $\mu$m was bonded to the X surface of the obtained piezoelectric film in the same manner as in Example 1. A coating layer D (thickness: 700 nm, refractive index: 1.50) was formed on the Y surface of the piezoelectric film of the obtained laminate in the same manner as in the coating layer A of Example 1.

(3) Formation of Coating Layer A

Next, a carrier film (polyethylene terephthalate) having a thickness of 125 $\mu$m was bonded onto the obtained coating layer D. Thereafter, the carrier film was peeled off from the X surface of the laminate, and a coating layer A (thickness: 728 nm, refractive index: 1.50) was formed on the exposed X surface of the piezoelectric film in the same manner as in Example 1.

(4) Formation of Coating Layer B

Next, an ultraviolet-curable composition containing zirconium oxide particles was applied onto the obtained coating layer A, dried at 80°C, and then irradiated with ultraviolet rays to form a coating layer B (thickness: 102 nm, refractive index: 1.70).

(5) Formation of Transparent Conductive Layer

Thereafter, a transparent conductive layer (thickness: 30 nm, refractive index: 1.92) was formed on the coating layer B in the same manner as in Example 1 to obtain a laminated piezoelectric body.

[Example 3]

(1) Preparation of Piezoelectric Film, Formation of Coating Layer A

In the same manner as in Example 1, a coating layer A (thickness: 1023 nm, refractive index: 1.50) was formed on the X surface of a piezoelectric film (refractive index: 1.42, thickness: 40 $\mu$m) in the same manner as in Example 1.

(2) Formation of Coating Layer B

Next, a coating layer B (thickness: 102 nm, refractive index: 1.65) was formed on the coating layer A in the same manner as in Example 2.

(3) Formation of Coating Layer C

Next, a coating layer C (thickness: 25 nm, refractive index: 1.46), which was a SiO$_2$ film, was formed on the upper surface of the coating layer B by a sputtering method using Si as a target material.

(4) Formation of Transparent Conductive Layer

Thereafter, a transparent conductive layer (thickness: 30 nm, refractive index: 1.92) was formed on the upper surface of the coating layer C in the same manner as in Example 1, thereby obtaining a laminated piezoelectric body.

[Example 4]

A piezoelectric film was prepared in the same manner as in Example 1 except that a DC voltage was applied while being increased to 14.0 kV.

Then, a laminated piezoelectric body was obtained in the same manner as in Example 3 except that the coating layer B, the coating layer C, and the transparent conductive layer were sequentially formed on the X surface of the piezoelectric film without forming the coating layer A.

[Comparative Example 1]

A laminated piezoelectric body was obtained in the same manner as in Example 1 except that the coating layer A (thickness: 1007 nm, refractive index: 1.50) was formed on the X surface of the piezoelectric film without bonding the carrier film.

[Comparative Example 2]

A laminated piezoelectric body was obtained in the same manner as in Comparative Example 1 except that the coating layer B (thickness: 87 nm, refractive index: 1.70) was formed between the coating layer A and the transparent conductive layer in the same manner as in Example 2.

Evaluation

The surface resistivity, piezoelectric constant $d_{33}$, total light transmittance, haze, and b* value of each of the obtained laminated piezoelectric bodies were evaluated by the following methods.

(1) Interference Fringes

In a dark room, each of the laminated piezoelectric bodies was visually observed under a three-wavelength fluorescent lamp ("LK-H766" available from TWINBIRD KOGYO K.K.) to determine whether or not there were interference fringes. A case where interference fringes were clearly visually recognized was evaluated as ×, a case where unevenness was slightly visually recognized but was not noticeable when carefully observed and interference fringes were not clearly confirmed was evaluated as ∘, and a case where unevenness was not recognized even when carefully observed and no interference fringe was confirmed was evaluated as ⊚.

(2) Surface Resistivity

The surface resistivity of the transparent conductive layer of each of the laminated piezoelectric bodies was measured using a resistivity meter ("LorestaGP MCP-T610", available from Nittoseiko Analytech Co., Ltd.) in accordance with JIS K 7194. The resistivity was measured three times, and the average value of the three times of measurement was used as a representative value.

(3) Piezoelectric Constant $d_{33}$

The piezoelectric constant $d_{33}$ was measured in accordance with ISO 19622:2018, which is a test method for the piezoelectric constant $d_{33}$ of piezoelectric ceramics by a direct quasi-static method ($d_{33}$ meter method, Berlincourt method). Specifically, the piezoelectric constant $d_{33}$ of each of the laminated piezoelectric bodies was measured by using a piezoelectric constant measuring device ("PiezoMeter System PM300", available from PIEZOTEST Pte Ltd) by clipping a sample at 1.0 N and reading the generated charge when a force of 0.15 N and 110 Hz was applied. The actual measurement value of the piezoelectric constant $d_{33}$ is a positive value or a negative value, depending on whether the front or back side of the film is measured; however, the absolute value is described in the present specification.

(4) Total Light Transmittance

The total light transmittance of each of the laminated piezoelectric bodies was measured using a haze meter ("NDH7000SP II", available from Nippon Denshoku Industries Co., Ltd.) based on the method described in JIS K 7361-1.

(5) Haze Value

The haze value of each of the laminated piezoelectric bodies was measured using a haze meter ("NDH7000SP II", available from Nippon Denshoku Industries Co., Ltd.) based on the method described in JIS K 7136.

(6) b* Value

The b* value of each of the laminated piezoelectric bodies was measured by a method in accordance with JIS Z 8722 using a spectral colorimeter ("SD7000", available from Nippon Denshoku Industries Co., Ltd.).

The layer configurations and physical properties of the laminated piezoelectric bodies of Examples 1 to 4 and Comparative Examples 1 to 2 are shown in Table 1, and the evaluation results of the laminated piezoelectric bodies are shown in Table 2.

[Table 1]

| | Piezoelectric film | | Coating layer A | | | Coating layer B | | | Coating layer C | | Transparent conductive layer | | Coating layer D | | |
| --- | --- | --- | --- | --- | --- | --- | --- | --- | --- | --- | --- | --- | --- | --- | --- |
| | Refractive index | Film thickness (μm) | Refractive index | Film thickness (nm) | Coefficient of Variation | Refractive index | Film thickness (nm) | Coefficient of Variation | Refractive index | Film thickness (nm) | Refractive index | Film thickness (nm) | Refractive index | Film thickness (nm) | Coefficient of Variation |
| Example 1 | 1.42 | 40 | 1.50 | 728 | 0.022 | - | - | - | - | - | 1.92 | 23 | - | - | - |
| Example 2 | 1.42 | 40 | 1.50 | 728 | 0.022 | 1.70 | 102 | 0.025 | - | - | 1.92 | 30 | 1.50 | 700 | 0.025 |
| Example 3 | 1.42 | 40 | 1.50 | 1023 | 0.024 | 1.65 | 102 | 0.025 | 1.46 | 25 | 1.92 | 30 | - | - | - |
| Example 4 | 1.42 | 40 | - | - | - | 1.70 | 750 | 0.023 | 1.46 | 25 | 1.92 | 30 | - | - | - |
| Comparative Example 1 | 1.42 | 40 | 1.50 | 1007 | 0.069 | - | - | - | - | - | 1.92 | 30 | - | - | - |
| Comparative Example 2 | 1.42 | 40 | 1.50 | 1007 | 0.069 | 1.70 | 87 | 0.056 | - | - | 1.92 | 30 | - | - | - |

**EP 4 699 797 A1**

[Table 2]

|  | Interference fringes | Surface resistivity ($\Omega$/sq.) | Piezoelectric constant $d_{33}$ (pC/N) | Total light transmittance (%) | Haze (%) | b* (-) |
|---|---|---|---|---|---|---|
| Example 1 | ○ | 215 | 17.2 | 87.1 | 0.7 | 2.8 |
| Example 2 | ◎ | 140 | 17.2 | 86.9 | 0.3 | 2.3 |
| Example 3 | ○ | 227 | 17.2 | 89.3 | 0.7 | 2.8 |
| Example 4 | ○ | 175 | 21.1 | 87.1 | 0.9 | 2.9 |
| Comparative Example 1 | × | 140 | 17.2 | 84.2 | 0.7 | 3.8 |
| Comparative Example 2 | × | 140 | 17.2 | 86.7 | 0.7 | 2.4 |

As shown in Table 2, it is shown that interference fringes occur in both the laminated piezoelectric bodies of Comparative Examples 1 and 2 in which the coefficient of variation of the thickness of the coating layer A or B exceeds 0.050.

In contrast, it is found that interference fringes are suppressed in all the laminated piezoelectric bodies of Examples 1 to 4 in which the coefficient of variation of the thickness of the coating layer A or B is 0.050 or less. It is also found that the transparency is high and the color tone is suppressed.

From these results, it is found that when the coefficient of variation of the thickness of the coating layer A or B is set to 0.050 or less, it is possible to suppress interference fringes while achieving high transparency and suppressing the color tone.

The present application claims priority from the Japanese Patent Application No. 2023-68483 filed on April 19, 2023. The contents described in the present specification and drawings of the foregoing application are all incorporated in the specification of the present application by reference.

## INDUSTRIAL APPLICABILITY

According to the laminated piezoelectric body of the present invention, it is possible to provide a laminated piezoelectric body which has high transparency and can suppress interference fringes when viewed under a three-wavelength light source, and a method for producing the same. Accordingly, the laminated piezoelectric body can be suitably used as a piezoelectric sensor of a touch panel.

## REFERENCE SIGNS LIST

10 Laminated piezoelectric body
11 Piezoelectric film,
12 Coating layer A
13 Coating layer B
14 Transparent conductive layer
15 Coating layer D
16 Coating layer C
20 Carrier film

## Claims

1. A laminated piezoelectric body having a total light transmittance of 80% or more, the laminated piezoelectric body comprising:

   a piezoelectric film containing a fluorine-based resin as a main component;
   a transparent conductive layer having a surface resistivity of $1.0 \times 10^4$ $\Omega$/sq. or less; and
   one or more coating layers disposed between the piezoelectric film and the transparent conductive layer, the coating layers each having a thickness of 0.05 $\mu$m or more, wherein
   each of the one or more coating layers has a refractive index higher than a refractive index of the piezoelectric film and lower than a refractive index of the transparent conductive layer, and

a thickness of at least one of the one or more coating layers has a coefficient of variation of 0.05 or less.

2. The laminated piezoelectric body according to claim 1, wherein

the piezoelectric film has a refractive index of 1.30 or more and 1.50 or less, and
the transparent conductive layer has a refractive index of 1.80 or more and 2.20 or less.

3. The laminated piezoelectric body according to claim 1, wherein

the one or more coating layers include a coating layer A having a refractive index of 1.40 or more and less than 1.60, and
a thickness of the coating layer A has a coefficient of variation of 0.05 or less.

4. The laminated piezoelectric body according to claim 3, wherein

the one or more coating layers further include a coating layer B disposed between the coating layer A and the transparent conductive layer,
the coating layer B has a refractive index of 1.60 or more and less than 1.80, and
a thickness of the coating layer B has a coefficient of variation of 0.05 or less.

5. The laminated piezoelectric body according to claim 1, further comprising

a coating layer D disposed on a surface of the piezoelectric film on a side opposite to a surface on which the one or more coating layers are disposed, wherein
the coating layer D has a refractive index of 1.40 or more and less than 1.60.

6. The laminated piezoelectric body according to claim 1, further comprising
a carrier film disposed on a surface of the piezoelectric film on a side opposite to a surface on which the one or more coating layers are disposed.

7. The laminated piezoelectric body according to claim 1, wherein
the fluorine-based resin is a polymer containing, as a main component, a structural unit derived from vinylidene fluoride.

8. A method for producing the laminated piezoelectric body described in claim 1, the method comprising:

preparing a piezoelectric film containing a fluorine-based resin as a main component;
bonding a carrier film to a surface of the piezoelectric film;
applying a coating liquid to a surface of the piezoelectric film other than the surface to which the carrier film is bonded and then drying the coating liquid to form one or more coating layers; and
on the one or more coating layers, forming a transparent conductive layer containing a metal oxide.

9. The method for producing the laminated piezoelectric body according to claim 8, wherein
a Young's modulus of the carrier film at 25°C is 1.0 GPa or more.

10. The method for producing the laminated piezoelectric body according to claim 8, wherein

the preparing of the piezoelectric film includes stretching
the film containing a fluorine-based resin as a main component, and then subjecting the film to a polarization treatment.

[FIG. 1]

10

14
13
12
11

[FIG. 2]

FIG. 2A

FIG. 2B

FIG. 2C

FIG. 2D

FIG. 2E

FIG. 2F

[FIG. 3]

10

14
12
11

FIG. 3A

10

14
13
12
11
15

FIG. 3B

10

14
16
13
12
11

FIG. 3C

10

14
16
13
11

FIG. 3D

## INTERNATIONAL SEARCH REPORT

| International application No. |
|---|
| **PCT/JP2024/010933** |

### A. CLASSIFICATION OF SUBJECT MATTER

**B32B 7/025**(2019.01)i; **B32B 7/023**(2019.01)i; **B32B 9/00**(2006.01)i; **B32B 27/30**(2006.01)i
FI:   B32B7/025; B32B7/023; B32B9/00 A; B32B27/30 D

According to International Patent Classification (IPC) or to both national classification and IPC

### B. FIELDS SEARCHED

Minimum documentation searched (classification system followed by classification symbols)

B32B1/00-43/00; G02B1/14; G02B1/16; H10N30/045; H10N30/077; H10N30/097; H10N30/857;C08J7/04-7/06; C08L27/12

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2022/220144 A1 (KUREHA CORP.) 20 October 2022 (2022-10-20)<br>whole document | 1-10 |
| A | JP 2019-096680 A (NITTO DENKO CORPORATION) 20 June 2019 (2019-06-20)<br>whole document | 1-10 |
| A | WO 2022/196198 A1 (KUREHA CORP.) 22 September 2022 (2022-09-22)<br>whole document | 1-10 |
| A | WO 2022/224671 A1 (KUREHA CORP.) 27 October 2022 (2022-10-27)<br>whole document | 1-10 |
| A | JP 2009-283348 A (TOYO BOSEKI KABUSHIKI KAISHA) 03 December 2009<br>(2009-12-03)<br>whole document | 1-10 |
| A | WO 2017/209081 A1 (NITTO DENKO CORPORATION) 07 December 2017 (2017-12-07)<br>whole document | 1-10 |

☑ Further documents are listed in the continuation of Box C.      ☑ See patent family annex.

| | |
|---|---|
| *    Special categories of cited documents: | "T"   later document published after the international filing date or priority date and not in conflict with the application but cited to understand the principle or theory underlying the invention |
| "A"   document defining the general state of the art which is not considered to be of particular relevance | |
| "D"   document cited by the applicant in the international application | "X"   document of particular relevance; the claimed invention cannot be considered novel or cannot be considered to involve an inventive step when the document is taken alone |
| "E"   earlier application or patent but published on or after the international filing date | |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| **15 May 2024** | **28 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

International application No.

**PCT/JP2024/010933**

| C. | DOCUMENTS CONSIDERED TO BE RELEVANT | |
|---|---|---|
| Category* | Citation of document, with indication, where appropriate, of the relevant passages | Relevant to claim No. |
| A | JP 2011-167914 A (TOYO BOSEKI KABUSHIKI KAISHA) 01 September 2011 (2011-09-01)<br>whole document | 1-10 |
| P, A | WO 2023/067899 A1 (KUREHA CORP.) 27 April 2023 (2023-04-27)<br>whole document | 1-10 |
| P, A | WO 2023/067900 A1 (KUREHA CORP.) 27 April 2023 (2023-04-27)<br>whole document | 1-10 |

Form PCT/ISA/210 (second sheet) (July 2022)

**INTERNATIONAL SEARCH REPORT**
Information on patent family members

| Patent document cited in search report | | | Publication date (day/month/year) | Patent family member(s) | | | Publication date (day/month/year) |
|---|---|---|---|---|---|---|---|
| WO | 2022/220144 | A1 | 20 October 2022 | EP | 4324641 | A1 | |
| | | | | whole document | | | |
| | | | | CN | 117044432 | A | |
| | | | | KR | 10-2023-0154984 | A | |
| | | | | TW | 202248319 | A | |
| JP | 2019-096680 | A | 20 June 2019 | WO | 2019/102635 | A1 | |
| | | | | CN | 111386613 | A | |
| | | | | KR | 10-2020-0089257 | A | |
| WO | 2022/196198 | A1 | 22 September 2022 | EP | 4310929 | A1 | |
| | | | | whole document | | | |
| | | | | CN | 116941347 | A | |
| | | | | KR | 10-2023-0146071 | A | |
| | | | | TW | 202237384 | A | |
| WO | 2022/224671 | A1 | 27 October 2022 | CN | 117016058 | A | |
| | | | | KR | 10-2023-0157437 | A | |
| JP | 2009-283348 | A | 03 December 2009 | (Family: none) | | | |
| WO | 2017/209081 | A1 | 07 December 2017 | JP | 2017-216451 | A | |
| | | | | CN | 109219895 | A | |
| | | | | KR | 10-2019-0013777 | A | |
| | | | | TW | 201743177 | A | |
| JP | 2011-167914 | A | 01 September 2011 | (Family: none) | | | |
| WO | 2023/067899 | A1 | 27 April 2023 | TW | 202317370 | A | |
| WO | 2023/067900 | A1 | 27 April 2023 | TW | 202318448 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017215960 A
- WO 2022196198 A

- JP 2023068483 A